Europäisches Patentamt

European Patent Office

Office européen des brevets

(11) Veröffentlichungsnummer: **0 289 807 B1**

## EUROPÄISCHE PATENTSCHRIFT

(45) Veröffentlichungstag der Patentschrift: **22.06.94**

(51) Int. Cl.5: **H03F 1/30**, H03G 1/04

(21) Anmeldenummer: **88105683.2**

(22) Anmeldetag: **09.04.88**

(54) **Verfahren zur Temperaturkompensation von elektrischen Netzwerken sowie Anordnungen hierzu.**

(30) Priorität: **06.05.87 DE 3714984**

(43) Veröffentlichungstag der Anmeldung:
**09.11.88 Patentblatt 88/45**

(45) Bekanntmachung des Hinweises auf die
Patenterteilung:
**22.06.94 Patentblatt 94/25**

(84) Benannte Vertragsstaaten:
**DE FR GB IT NL SE**

(56) Entgegenhaltungen:
WO-A-84/04215         DE-C- 3 622 615
FR-A- 1 588 854       US-A- 2 920 278
US-A- 3 715 609       US-A- 4 595 885
US-A- 4 596 961

(73) Patentinhaber: **ANT Nachrichtentechnik GmbH**
**Gerberstrasse 33**
**D-71522 Backnang(DE)**

(72) Erfinder: **Wunderlich, Hans Werner, Dipl.-Ing.**
**Gartenstrasse 3**
**D-5927 Erndtebrück(DE)**
Erfinder: **Czech, Johannes, Dr. rer. nat.**
**Richard-Wagner-Strasse 3**
**D-7150 Allmersbach i.T.(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 289 807 B1

**Beschreibung**

Die Erfindung geht aus von einer Anordnung zur Temperaturkompensation gemäß dem Oberbegriff des Patentanspruchs 1 oder 7.

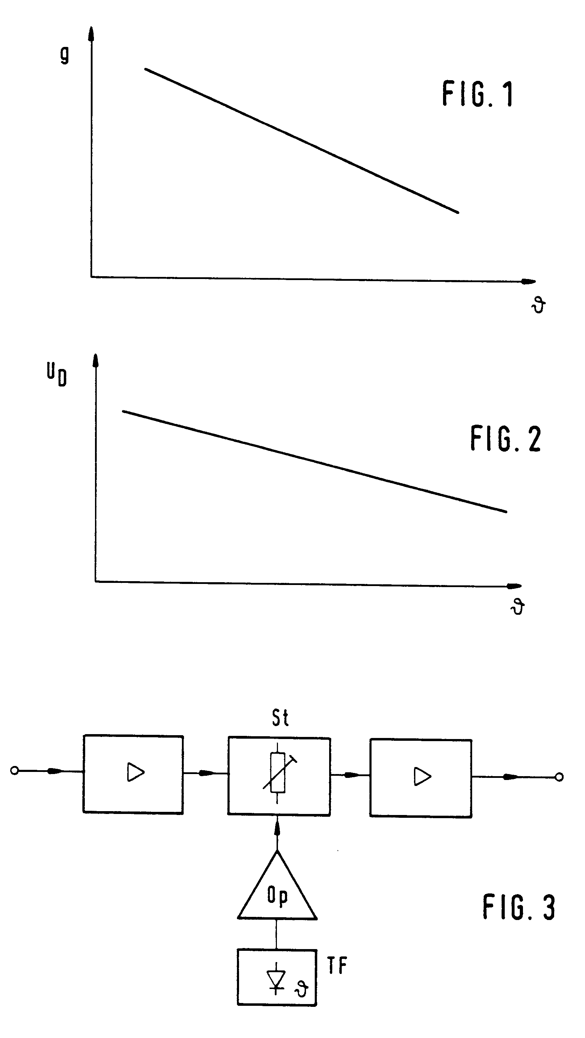

Ein Halbleiterverstärker, insbesondere eine FET-Verstärker im Mikrowellenbereich, ohne zusätzliche Einstellmöglichkeit der Verstärkung g über einen kleinen Dynamikbereich ($\Delta g \leq 10$ dB) weist über einem definierten Temperaturbereich ($\Delta\vartheta$) eine monoton fallende lineare Temperaturänderung der Verstärkung auf (Fig. 1). Solche linearen Temperaturänderungen der Verstärkung lassen sich auf einfache Weise durch temperaturabhängige Widerstände (NTC/PTC) und einem entsprechenden Widerstandsnetzwerk durch Arbeitspunkt- oder Stellgliedsteuerung oder durch Silizium-Dioden bei Betrieb im Knickspannungsbereich kompensieren. Ein Beispiel für eine solche Kompensation zeigt Fig. 3. Das Stellglied St besteht dabei beispielsweise aus PIN-Dioden und der Temperaturfühler TF aus einer Diode, deren Temperaturverhalten bezüglich der Diodenspannung $U_D$ in Fig. 2 wiedergegeben. ist. Mittels des Temperaturfühlers TF wird eine temperaturabhängige Spannung erfaßt, über einen Operationsverstärker Op verstärkt und damit ein entsprechendes Stellglied St des Verstärkers gesteuert.

Aus Elektronik; 1981, Nr. 5, Seiten 121 bis 122, ist ein Verfahren zur Temperaturkompensation bei Meßgrößen bekannt.

Das Temperaturverhalten eines Meßsignals $1 + \alpha\Delta\vartheta$ wird dort durch eine Schaltung kompensiert, die das Verhalten $(1 + \alpha\Delta\vartheta)^{-1}$ hat. Diese Schaltung enthält ein Additionsglied, das eine von einer Temperaturspannung abgeleitete einstellbare Größe mit einer Referenzgröße verknüpft. Es findet dort zwar eine multiplikative Verknüpfung eines Referenzsignals mit einer temperaturabhängigen Größe statt, aber keine multiplikative Verknüpfung des Temperaturkoeffizienten der Kompensationsgröße mit der Steuergröße für den Verstärkungsgrad. Die Kompensation funktioniert dort nur, wenn der Temperaturgang des Übertragungsfaktors innerhalb des Stellbereichs konstant ist. Eine Temperaturkompensation des Temperaturgangs des Übertragungsfaktors in einem weiten Einstellbereich ist dort nicht möglich.

Ein aus der US 2,920,278 bekannter Verstärker, dessen Verstärkung einstellbar ist, weist eine Temperaturkompensation auf, die auf der multiplikativen Verknüpfung von ausgewählten Signalen beruht. Die Verstärkung ist dort in einem weiten Temperaturbereich konstant. Die Temperaturabhängigkeit der Verstärkung bei Ändern eines Stellsignals, d.h. eines Signals zur Einstellung der Verstärkung, ist dort nicht berücksichtigt.

Aus US-A-4,595,885 ist eine Temperaturkompensation eines Halbleiterverstärkers als Bestandteil eines einstellbaren aktiven Filters bekannt. Die Resonanzfrequenz des aktiven Filters wird dort durch Variieren des Bias-Stromes eines Transkonduktanz-Verstärkers nachgestellt. Dieser Bias-Strom wird über ein Temperaturkompensations-Netzwerk erzeugt, in welchem das Ausgangssignal einer Stromquelle mit einem Stellsignal zur Änderung der Resonanzfrequenz des aktiven Filters verknüpft wird. In einer Transistorstufe werden Stellsignale und Ausgangssignale der Stromquelle verknüpft, wobei zur Temperaturkompensation dieser Transistorstufe eine herkömmliche Emitterstromgegenkopplung verwendet wird.

Bei der US 4,596,961 wird ein temperaturabhängiges Signal mit einem Referenzsignal multiplikativ verknüpft. Das Referenzsignal ist dort nicht verstärkungsabhängig.

In der WO 84/04215 wird ein Halbleiterverstärker mit einstellbarem Übertragungsfaktor aufgezeigt, wobei ein verstärkungsabhängiges Referenzsignal vorgegeben ist. Es erfolgt dort eine Signalauswahl für die Verstärkungseinstellung in Abhängigkeit der Ausgangsleistung des Verstärkers.

Aus den Veröffentlichen Microwave System News, December 1983, Seiten 86 - 104 und EDN, Vol. 30, June 1985, Seite 193, ist es prinzipiell bekannt, einem Halbleiterverstärker zur Temperaturkompensation ein stromgesteuertes PIN-Diodendämpfungsglied nachzuschalten.

Aufgabe der Erfindung ist es, eine Anordnung gemäß Oberbegriff des Patentanspruchs 1 oder 7 so auszugestalten, daß eine Temperaturkompensation über einen großen Einstellbereich (Dynamik) des Übertragungsfaktors gewährleistet ist. Diese Aufgabe wird durch die Merkmale der Ansprüche 1 oder 7 gelöst. Die übrigen Ansprüche zeigen vorteilhafte Ausgestaltungen der Anordnung auf. Die Erfindung geht von folgenden Erkenntnissen aus: Sollen Verstärker, insbesondere Mikrowellensignalverstärker, mit großem Verstärkungsbereich temperaturkompensiert werden, muß das Temperaturverhalten der einzelnen Verstärkerkomponenten berücksichtigt werden. Im wesentlichen gilt das für die reinen Verstärkermodule und das Stellglied, z.B. PIN-Diodendämpfungsglieder. Dabei zeigen die reinen Verstärkermodule einen etwa konstanten negativen Temperaturkoeffizienten der Verstärkung und das Stellglied - PIN-Diodendämpfungsglied - einen von der jeweiligen Einstellung abhängigen etwa konstanten positiven Temperaturkoeffizienten der Dämpfung.

Nach außen zeigt der Gesamtverstärker dann durch die Überlagerung der oben erwähnten Effekte je nach Verstärkungseinstellung über der Temperatur einmal zunehmende Verstärkung und einmal weniger zunehmende oder gar abnehmende Verstärkung.

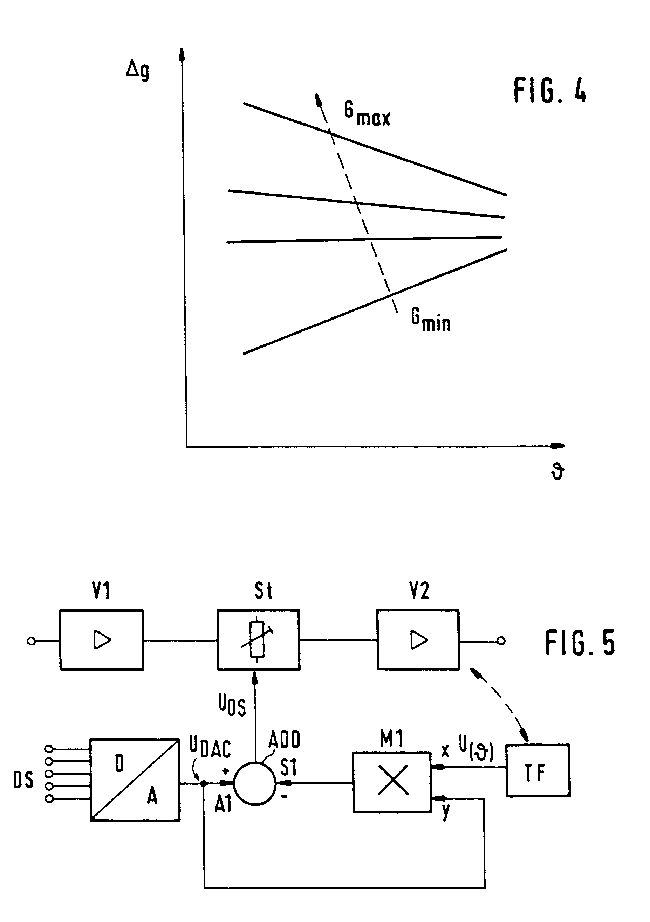

Fig. 4 zeigt das Verhalten eines solchen unkompensierten Verstärkers. Dort ist die Verstärkungsabweichung $\Delta g$ in Abhängigkeit der Temperatur $\vartheta$ mit der Verstärkung G als Parameter dargestellt. $G_{min}$ und $G_{max}$ geben die betriebsmäßig einstellbare minimale bzw. maximale Verstärkung an. Durch die erfindungsgemäßen Maßnahmen wird diese Temperaturabhängigkeit für einen großen Dynamikbereich kompensiert.

Die Anordnung nach der Erfindung kann nicht nur zur Temperaturkompensation des Betrages des Übertragungsfaktors (Verhältnis von Ausgangs- und Eingangssignal) des Netzwerkes verwendet werden, sondern auch zur Temperaturkompensation der Phase des Übertragungsfaktors. Damit sind temperaturkompensierte Phasenschieber realisierbar.

Anhand der weiteren Zeichnungen werden Ausführungsbeispiele der Erfindung nun näher erläutert.
Es zeigen

Fig. 5     ein Prinzipschaltbild eines Verstärkers nach der Erfindung,

Fig. 6     einen Stromlaufplan der Verstärkerbeschaltung nach der Erfindung,

Fig. 7     Einzelheiten der Verstärkermodule,

Fig. 8     Einzelheiten des Stellgliedes,

Fig. 9     Das Temperaturverhalten des kompensierten Verstärkers und

Fig. 10     Meßergebnisse.

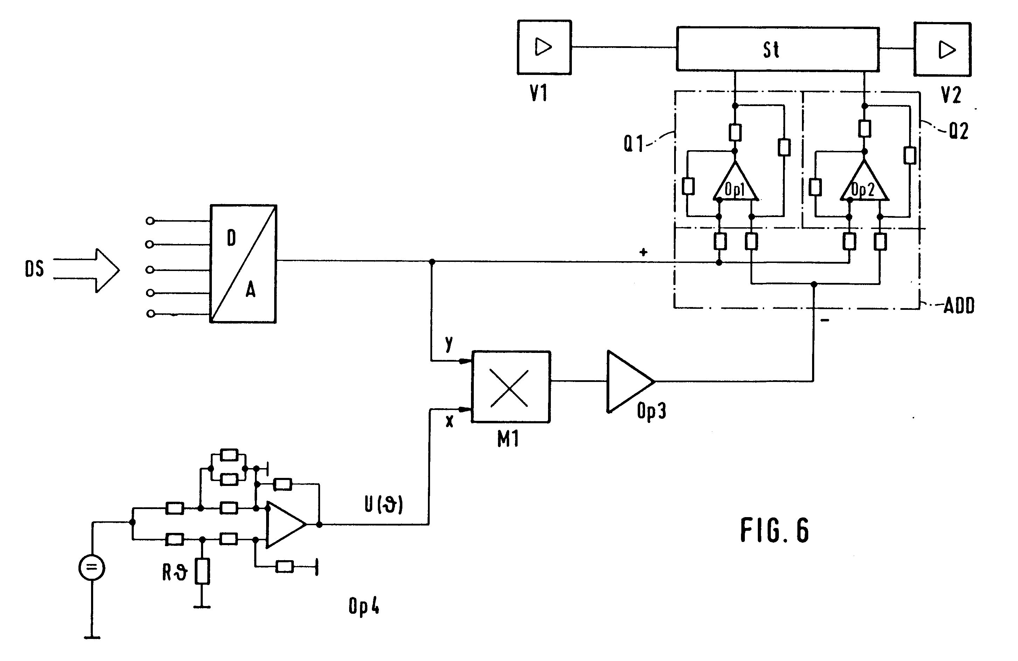

Der Halbleiterverstärker nach Fig. 5 besteht aus zwei Verstärkerstufen V1 und V2, zwischen denen das Stellglied St - PIN-Dioden-Dämpfungsglied - angeordnet ist. Ein Temperaturfühler TF ist mit mindestens einem Verstärkerbauelement thermisch gekoppelt. Der Ausgang des Temperaturfühlers TF - Spannung $U(\vartheta)$ - ist mit dem ersten Eingang - x - eines Analogmultiplizierers M1 verbunden. Dem zweiten Eingang - y - des Analogmultiplizierers M1 ist eine von der Verstärkungseinstellung abhängige Spannung $U_{DAC}$ zugeführt. Der Analogmultiplizierer M1 verknüpft somit eine Größe, die der Verstärkertemperatur proportional ist mit einer Größe, die eine monotone Funktion der Steuergröße des Stellgliedes St ist. Mit dem Ausgangssignal $U = m \cdot U_{DAC} \cdot U(\vartheta)$ des Analogmultiplizierers M1 wird der erste Addiereingang S1 eines Addierers ADD beaufschlagt. Dem Addierer ADD wird an seinem zweiten Addiereingang A1 die Spannung $U_{DAC}$ zugeführt. Die Spannung $U_{DAC}$ ist bei dem vorgestellten Ausführungsbeispiel negativ. Der Ausgang des Addierers ADD führt eine Offsetspannung $U_{OS}$, welche dem aus PIN-Dioden bestehenden Stellglied St zugeführt wird. Wie Fig. 6 zeigt, wird das Stellglied St über zwei Stromquellen Q1, Q2 betrieben, die jeweils durch beschaltete Operationsverstärker Op1, Op2 realisiert sind. Als Multiplizierer M1 kann ein handelsüblicher integrierter Schaltkreis, beispielsweise mit nachgeschalteter Treiberstufe Op3 eingesetzt werden. Der Multiplizierer ist hier als Vierquadratantenmultiplizierer ausgebildet. Die Addierstufe ADD1 ist hier durch eine wired-or Verdrahtung ersetzt. Der Temperaturfühler TF besteht aus einem eingangsseitig mit zwei Widerstand-T-Netzwerken beschalteten Operationsverstärker Op4. Im Querzweig jenes T-Gliedes, das mit dem nichtinvertierenden Eingang des Operationsverstärkers Op4 verbunden ist, befindet sich ein temperaturempfindlicher Widerstand $R_\vartheta$ mit linearer Temperatur-/Widerstandskennlinie, der thermisch mit den Verstärkerelementen gekoppelt ist. Die Verstärkungssteuerspannung $U_{DAC}$ wird durch eine Verarbeitungsstufe - D/A -Wandlung - aus einem Datensignal DS abgeleitet. Dieses Datensignal DS, das Informationen über die einzustellende Verstärkung des Verstärkers enthält, wird - falls der Verstärker als Kanalverstärker in einem Satelliten untergebracht ist - von einer Bodenstation als Telekommandsignal zum Satelliten übertragen.

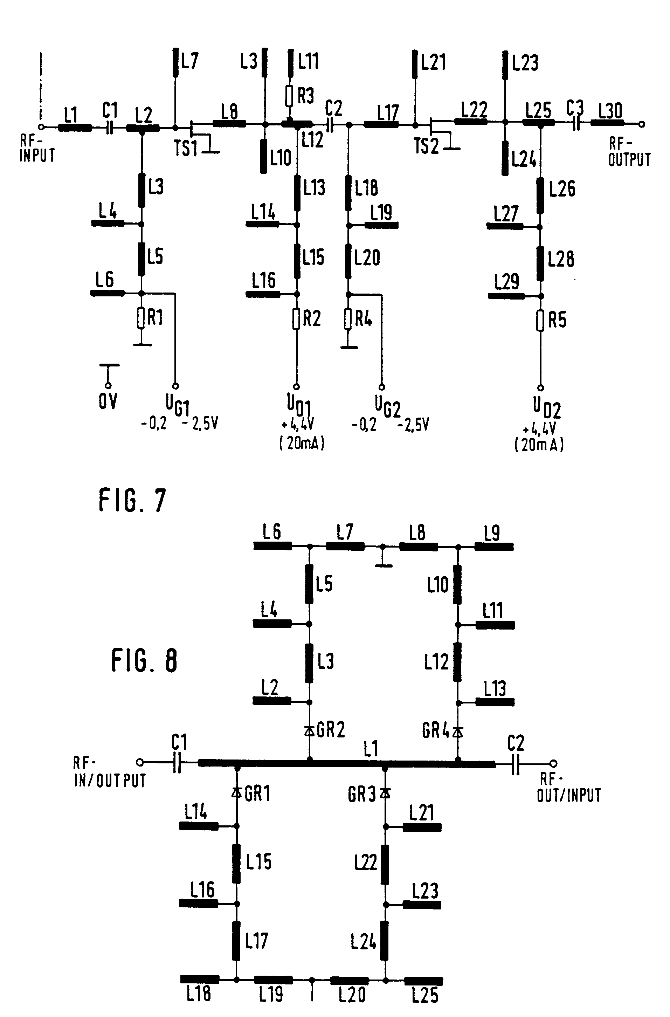

Die Einzelheiten der Verstärkermodule V1 und V2 sind in Fig. 7 dargestellt. Es sind jeweils zwei in Kette geschaltete FET-Verstärkerbauelemente TS1 und TS2 vorgesehen. Die Drain-Versorgungsspannungen $U_{D1}$, $U_{D2}$ bzw. die Gate-Steuerspannungen $U_{G1}$, $U_{G2}$ werden über Widerstände und Leitungskreise L1 ... L30 zugeführt. Die Kondensatoren C1 bis C3 dienen zur galvanischen Stufenentkopplung.

Das Stellglied St besteht aus einem oder mehreren PIN-Diodendämpfungsgliedern gemäß Fig. 8. Es ist eine PIN-Diodenparallelschaltung im $\lambda/4$-Abstand vorgesehen mit 4 PIN-Dioden GR1 ... GR4 und Leitungskreisen L1 ... L25. Die beiden Zweige werden symmetrisch über einen Steuereingang SE von der Stromquelle Q1 gesteuert. Die weitere Stromquelle Q2 steuert ein gleichartig aufgeboutes weiteres PIN-Dioden-Dämpfungsglied.

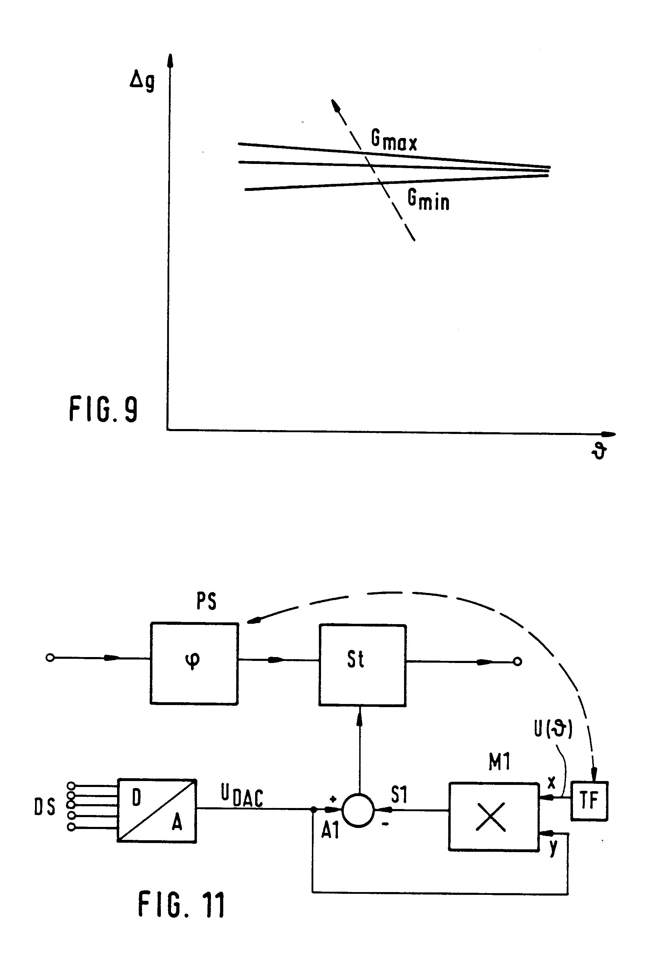

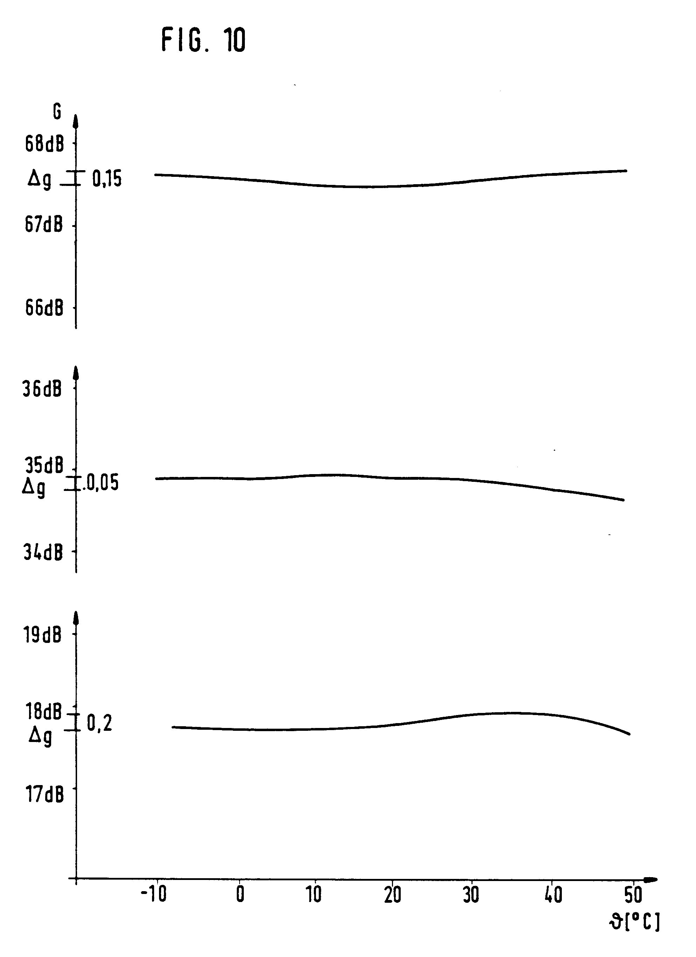

Den qualitativen Verlauf der Verstärkungsabweichung $\Delta g$ des kompensierten Verstärkers in Abhängigkeit der Temperatur $\vartheta$ mit der Verstärkung G als Parameter zeigt Fig. 9. Wie ein Vergleich mit Fig. 4 zeigt, ist die Verstärkungsabweichung wesentlich geringer. Fig. 10 zeigt Meßergebnisse des Temperaturverhaltens bei mehreren Pegelwerten der Verstärkung (68, 35 und 18 dB).

Die Verstärkungsabweichung $\Delta g$ liegt im erfaßten Temperaturbereich von - 10° C ... + 50° C unter 0,2 dB.

Das Stellglied kann in anderen Ausführungsbeispielen aus Single- oder Dual-Gate-Feldeffekttransistoren oder Varaktordioden bestehen.

Das Stellglied in Verbindung mit dem Multiplizierer kann sowohl zur Temperturkompensation des Betrages des Übertragungsfaktors als auch zur Temperaturkompensation der Phase des Übertragungsfaktors herangezogen werden. Fig. 11 zeigt ein Ausführungsbeispiel mit einer Temperaturkompensation der Phase des Übertragungsfaktors. Das Netzwerk ist hier als Phasenschieber PS ausgebildet. Das Stellglied St für diesen Phasenschieber PS wird über den Multiplizierer M1 gesteuert, der wie beim Ausführungsbeispiel gemäß Fig. 5 eine Steuergröße $U_{DAC}$, die hier allerdings zur Phaseneinstellung dient, multiplikativ mit einer zur gemeinsamen Temperatur der Phasenschieberbauelemente proportionalen Größe $U_{(\vartheta)}$ verknüpft.

Anstelle der Steuerung des Übertragungsfaktors über ein Stellglied kann die durch multiplikative Verknüpfung gebildete Größe auch zur Arbeitspunktnachsteuerung herangezogen werden.

## Patentansprüche

1. Anordnung zur Temperaturkompensation eines Halbleiterverstärkers, dessen Verstärkungsfaktor ein monotones Temperaturerhalten aufweist, wobei in den Verstärkungsweg ein Stellglied (St) mit einstellbarem Übertragungsfaktor geschaltet ist, das zur Regelung des Verstärkungsfaktors des Verstärkers aufgrund eines extern zugeführten Referenzsignals ($U_{DAC}$) und zur Temperaturkompensation des Verstärkungsfaktors aufgrund eines der Temperatur des Verstärkers proportionalen Meßsignals ($U_{(\vartheta)}$)) vorgesehen ist, wobei durch eine multiplikative Verknüpfung des Meßsignals mit dem Referenzsignal ein Stellsignal für das dem Halbleiterverstärker zugeordnete Stellglied erzeugt wird, gekennzeichnet durch
    - einen Multiplizierer (M1), dem das in etwa zur Temperatur der Elemente des Verstärkers proportionale Meßsignal ($U_{(\vartheta)}$)) und das Referenzsignal ($U_{DAC}$) zur Einstellung des gewünschten Übertragungsfaktors des Stellgliedes zuführbar ist,
    - einen Addierer (ADD), dessen erster Eingang (S1) mit dem Ausgang des Multiplizierers (M1) verbunden ist und dessen zweiter Eingang (A1) mit dem Referenzsignal ($U_{DAC}$) beaufschlagbar ist,
    - eine Verbindung zwischen dem Ausgang des Addierers (ADD) und dem Stelleingang des Stellgliedes (St).

2. Anordnung nach Anspruch 1, dadurch gekennzeichnet, daß das Stellglied (St) aus einer oder mehreren PIN-Diode/n, aus einer oder mehreren Varaktordioden/n oder aus einem oder mehreren Single- oder Dual-Gate-Feldeffekttransistor/en besteht.

3. Anordnung nach Anspruch 1 oder 2, dadurch gekennzeichnet, daß der Verstärker mehrstufig aufgebaut ist, und daß das Stellglied (St) zwischen zwei Verstärkerstufen (V1, V2) angeordnet ist.

4. Anordnung nach Anspruch 1, 2 oder 3, dadurch gekennzeichnet, daß das Stellglied (St) aus über Stromquellen (Q1, Q2) steuerbaren PIN-Dioden-Dämpfungsgliedern (GR1, GR4) besteht.

5. Anordnung nach Anspruch 4, dadurch gekennzeichnet, daß das Ausgangssignal des Multiplizierers (M1) zur Steuerung der Stromquellen (Q1, Q2) herangezogen wird.

6. Anordnung nach einem der Ansprüche 2 bis 5, dadurch gekennzeichnet, daß ein Temperaturfühler (TF) vorgesehen ist, der mit den Verstärkerbauelementen (TS1, TS2, St) thermisch gekoppelt ist, daß der Ausgang des Temperaturfühlers (TF) mit einem ersten Eingang (x) des Multiplizierers (M1) verbunden ist und daß der Ausgang einer Stufe (D/A) zur Verarbeitung der Steuergröße für die Verstärkung als Referenzsignal ($U_{DAC}$) sowohl mit dem zweiten Eingang (A1) des Addierers (ADD) als auch mit einem zweiten Eingang (y) des Multiplizierers (M1) verbunden ist.

7. Anordnung zur Temperaturkompensation eines Phasenschiebers, dessen Phase ein monotones Temperaturverhalten aufweist und dem ein Stellglied nachgeschaltet ist, wobei das Stellglied (St) zur Phaseneinstellung mittels eines externen Referenzsignals ($U_{DAC}$) und zur Temperaturkompensation des Phasenschiebers mittels eines Meßsignals, das der Temperatur des Phasenschiebers proportional ist, vorgesehen ist, wobei durch eine multiplikative Verknüpfung des Meßsignals ($U(\vartheta)$) mit dem Referenzsignal ($U_{DAC}$) das Stellsignal für das dem Phasenschieber zugeordnete Stellglied gebildet wird, gekennzeichnet durch
    - einen Multiplizierer (M1), dem das in etwa zur Temperatur der Elemente des Verstärkers proportionale Meßsignal ($U_{(\vartheta)}$)) und das Referenzsignal ($U_{DAC}$) zur Einstellung der Phase des Stellgliedes zuführbar ist,
    - einen Addierer, dessen erster Eingang (S1) mit dem Ausgang des Multiplizierers (M1) verbunden ist und dessen zweiter Eingang (A1) mit dem Referenzsignal ($U_{DAC}$) beaufschlagbar ist,
    - eine Verbindung zwischen dem Ausgang des Addierers (ADD) und dem Stelleingang des Stellgliedes (St).

**8.** Anordnung nach Anspruch 7, dadurch gekennzeichnet, daß ein Temperaturfühler (TF) vorgesehen ist, der mit den Phasenschieberbauelementen thermisch gekoppelt ist, daß der Ausgang des Temperaturfühlers (TF) mit einem ersten Eingang (x) des Multiplizierers (M1) verbunden ist und daß der Ausgang einer Stufe (D/A) zur Verarbeitung der Steuergröße für die Phase als Referenzsignal ($U_{DAC}$) sowohl mit dem zweiten Eingang (A1) des Addierers (ADD) als auch mit einem zweiten Eingang (y) des Multiplizierers (M1) verbunden ist.

**Claims**

**1.** Arrangement for the temperature compensation of a semiconductor amplifier, the amplification factor of which displays a monotonic temperature behaviour, in which arrangement a setting member (St) of adjustable transmission factor is connected into the amplification path and provided for the regulation of the amplification factor of the amplifier on the basis of an externally supplied reference signal ($U_{DAC}$) and for the temperature compensation of the amplification factor on the basis of a measurement signal ($U(\vartheta)$) proportional to the temperature of the amplifier, wherein a setting signal for the setting member associated with the semiconductor amplifier is produced by a multiplicative interlinking of the measurement signal with the reference signal, characterised by
- a multiplier (M1), to which the measurement signal ($U(\vartheta)$), which is about proportional to the temperature of the elements of the amplifier, and the reference signal ($U_{DAC}$) for the adjustment of the desired transmission factor are feedable,
- an adder (ADD), the first input (S1) of which is connected with the output of the multiplier (M1) and the second input (A1) of which is loadable by the reference signal ($U_{DAC}$) and
- a connection between the output of the adder (ADD) and the setting input of the setting member (St).

**2.** Arrangement according to claim 1, characterised thereby, that the setting member (St) consists of one or more PIN diodes, of one or more varactory diodes or of one or more single-gate or dual-gate field effect transistors.

**3.** Arrangement according to claim 1 or 2, characterised thereby, that the amplifier is built up in several stages and that the setting member (St) is arranged between two amplifier stages (V1, V2).

**4.** Arrangement according to claim 1, 2 or 3, characterised thereby, that the setting member (St) consists of PIN diode attenuation members (GR1, GR4) controllable by way of current sources (Q1, Q2).

**5.** Arrangement according to claim 4, characterised thereby, that the output signal of the multiplier (M1) is drawn upon for the control of the current sources (Q1, Q2).

**6.** Arrangement according to one of the claims 2 to 5, characterised thereby, that a temperature sensor (TF) is provided, which is coupled thermally with the amplifier components (TS1, TS2, St), that the output of the temperature sensor (TF) is connected with a first input (x) of the multiplier (M1) and that the output of a stage (D/A) for the processing of the control magnitude for the amplification as the reference signal ($U_{DAC}$) is connected with the second input (A1) of the adder (ADD) as well as also with a second input (y) of the multiplier (M1).

**7.** Arrangement for the temperature compensation of a phase shifter, the phase of which displays a monotonic temperature behaviour and behind which a setting member is connected, wherein the setting member (St) is provided for the phase adjustment by means of an eternal reference signal ($U_{DAC}$) and for the temperature compensation of the phase shifter by means of a measurement signal proportional to the temperature of the phase shifter, wherein the setting signal for the setting member associated with the phase shifter is formed by a multiplicative interlinking of the measurement signal ($U(\vartheta)$) with the reference signal ($U_{DAC}$), characterised by
- a multiplier (M1), to which the measurement signal ($U(\vartheta)$), which is about proportional to the temperature of the elements of the amplifier, and the reference signal ($U_{DAC}$) for the adjustment of the phase of the setting member are feedable,
- an adder (ADD), the first input (S1) of which is connected with the output of the multiplier (M1) and the second input (A1) of which is loadable by the reference signal ($U_{DAC}$) and
- a connection between the output of the adder (ADD) and the setting input of the setting member (St).

**8.** Arrangement according to claim 7, characterised thereby, that a temperature sensor (TF) is provided, which is coupled thermally with the phase shifter components, that the output of the temperature sensor (TF) is connected with a first input (x) of the multiplier (M1) and that the output of a stage (D/A) for the processing of the control magnitude for the phase as the reference signal ($U_{DAC}$) is connected with the second input (A1) of the adder (ADD) as well as also with a second input (y) of the multiplier (M1).

## Revendications

**1.** Dispositif pour la compensation en température d'un amplificateur à semi-conducteurs dont le facteur d'amplification présente un comportement en température monotone, avec interposition dans le trajet d'amplification d'un élément de réglage (St) à facteur de transfert réglable, qui est prévu pour la régulation du facteur d'amplification de l'amplificateur sur la base d'un signal de référence ($U_{DAC}$) amené de l'extérieur et pour la compensation en température du facteur d'amplificateur sur la base d'un signal de mesure ($U(\vartheta)$) proportionnel à la température de l'amplificateur, avec génération, par une combinaison multiplicative du signal de mesure avec le signal de référence, d'un signal de réglage pour l'élément de réglage coordonné à l'amplificateur à semi-conducteurs, caractérisé par
- un multiplicateur (M1), auquel peuvent être amenés le signal de mesure ($U(\vartheta)$) à peu près proportionnel à la température des composants de l'amplificateur et le signal de référence ($U_{DAC}$) pour le réglage du facteur de transfert désiré de l'élément de réglage,
- un additionneur (ADD) dont la première entrée (S1) est reliée à la sortie du multiplicateur (M1) et à la seconde entrée (A1) duquel peut être appliqué le signal de référence ($U_{DAC}$) et
- une liaison entre la sortie de l'additionneur (ADD) et l'entrée de réglage de l'élément de réglage (St).

**2.** Dispositif selon la revendication 1, caractérisé en ce que l'élément de réglage (St) est constitué d'une ou plusieurs diode(s) PIN, d'une ou plusieurs diode(s) à capacité variable (varactor(s)) ou d'un ou plusieurs transistor(s) à effet de champ à grille unique ou à double grille.

**3.** Dispositif selon la revendication 1 ou 2, caractérisé en ce que l'amplificateur est de structure à plusieurs étages et que l'élément de réglage (St) est disposé entre deux étages amplificateurs (V1, V2).

**4.** Dispositif selon la revendication 1, 2 ou 3, caractérisé en ce que l'élément de réglage (St) est constitué d'éléments d'atténuation à diodes PIN (GR1, GR4) susceptibles d'être commandés par des sources de courant (Q1, Q2).

**5.** Dispositif selon la revendication 4, caractérisé en ce que le signal de sortie du multiplicateur (M1) est utilisé pour la commande des sources de courant (Q1, Q2).

**6.** Dispositif selon une des revendications 2 à 5, caractérisé en ce qu'un capteur de température (TF) est prévu, lequel est couplé thermiquement aux composants de l'amplificateur (TS1, TS2, St), que la sortie du capteur de température (TF) est reliée à une première entrée (x) du multiplicateur (M1) et que la sortie d'un étage (N/A) pour le traitement de la grandeur de commande de l'amplification, en tant que signal de référence ($U_{DAC}$), est reliée à la fois à la seconde d'entrée (A1) de l'additionneur (ADD) et à une seconde entrée (y) du multiplicateur (M1).

**7.** Dispositif pour la compensation en température d'un déphaseur dont la phase présente un comportement en température monotone et qui est suivi d'un élément de réglage, dispositif dans lequel l'élément de réglage (St) est prévu pour le réglage de phase au moyen d'un signal de référence externe ($U_{DAC}$) et pour la compensation en température du déphaseur au moyen d'un signal de mesure proportionnel à la température du déphaseur, et dans lequel le signal de réglage pour l'élément de réglage coordonné au déphaseur est formé par une combinaison multiplicative du signal de mesure ($U(\vartheta)$) avec le signal de référence ($U_{DAC}$), caractérisé par
- un multiplicateur (M1) auquel peuvent être amenés le signal de mesure ($U(\vartheta)$) à peu près proportionnel à la température des composants de l'amplificateur et le signal de référence ($U_{DAC}$ pour le réglage de la phase de l'élément de réglage,
- un additionneur dont la première entrée (S1) est reliée à la sortie du multiplicateur (M1) et à la seconde entrée (A1) duquel peut être appliqué le signal de référence ($U_{DAC}$) et

- une liaison entre la sortie de l'additionneur (ADD) et l'entrée de réglage de
l'élément de réglage (St).

8.   Dispositif selon la revendication 7, caractérisé
en ce qu'un capteur de température (TF) est
prévu, lequel est couplé thermiquement aux
composants du déphaseur, que la sortie du
capteur de température (TF) est reliée à une
première entrée (x) du multiplicateur (M1) et
que la sortie d'un étage (N/A) pour le traitement de la grandeur de commande de la phase, en tant que signal de référence ($U_{DAC}$), est
reliée à la fois à la seconde entrée (A1) de
l'additionneur (ADD) et à une seconde entrée
(y) du multiplicateur (M1).

FIG. 1

FIG. 2

FIG. 3

FIG. 4

FIG. 5

FIG. 6

EP 0 289 807 B1

FIG. 7

FIG. 8

FIG. 9

FIG. 11

# FIG. 10